# EUROPEAN PATENT APPLICATION

(11) **EP 4 810 305 A1**
(43) Date of publication of application: **23.09.2026**
(21) Application number: 24906208.4
(22) Date of filing: 11.12.2024
(51) Int. Cl.: B60L 53/31, B60L 53/302, B01D 46/10

(54) **LIGHT CHARGING PILE**

(30) Priority: 20.12.2023 CN 202323487122 U
(71) Applicant: ZHEJIANG ZEEKR INTELLIGENT TECHNOLOGY CO., LTD., Ningbo, Zhejiang 315899 (CN); Zhejiang Geely Holding Group Co., Ltd., Hangzhou, Zhejiang 310051 (CN)
(72) Inventor: YAN, Mei, Ningbo, Zhejiang 315899 (CN)
(74) Representative: Boult Wade Tennant LLP
(86) International application number: PCT/CN2024/138625
(87) International publication number: WO 2025/130725

(57) **Abstract**

A light-duty charging pile includes a light-duty charging pile body (100), a charging assembly (200), an air inlet mechanism (300) and an air exhaust mechanism (400). The air inlet mechanism (300) is provided with an air inlet box (310) and a filter assembly (320) disposed in the air inlet box (310). The outside air enters the air inlet box (310) through an air inlet (3101), and then passes through the filter assembly (320). The filter assembly (320) filters the outside air, so that the clean air enters the interior of the light-duty charging pile body (100) through an air outlet (3102). The dust and the moisture will not enter an interior of the light-duty charging pile through the air inlet (3101).

## Description

The present application claims priority to Chinese patent application No. 202323487122.1, filed with China National Intellectual Property Administration on December 20, 2023 and entitled "Light-duty Charging Pile", which is hereby incorporated by reference in its entirety.

### TECHNICAL FIELD

The present application relates to the technical field of new energy vehicle supplies, in particular to a light-duty charging pile.

### BACKGROUND

During the research and development stage of new energy electric vehicles, a significant amount of man-hours is typically invested in investigating the adaptability of charging piles across various regions of the country.

In existing light-duty charging pile, a charging-pile plug simulator is plugged and mated with a vehicle charging socket, and a vehicle socket simulator is plugged and mated with a charging-pile plug, which enables a fast charging test device to be connected in series between a vehicle and a charging-pile, such that the electric vehicle is charged, while the charging-pile and the electric vehicle are evaluated and tested, and a charging fault is quickly located. During the charging and testing process of the light-duty charging pile, a large amount of heat generated during operation accumulates inside the light-duty charging pile. The light-duty charging pile is provided with a ventilation opening for heat dissipation purposes.

However, dust and moisture in the air may enter the interior of the light-duty charging pile through the ventilation opening, affecting normal operation of components of the light-duty charging pile, and further affecting test-and-evaluation data of the light-duty charging pile.

### SUMMARY

The purpose of the present application is to provide a light-duty charging pile for testing and evaluating a vehicle and a charging-pile.

The following is a summary of the subject matters described in detail in this specification. This summary is not intended to limit the protection scope of the claims.

The present application provides a light-duty charging pile, including a light-duty charging pile body, a charging assembly, an air inlet mechanism and an air exhaust mechanism;
the light-duty charging pile body is configured to connect to a charging-pile;
the charging assembly is disposed on the light-duty charging pile body, and the charging assembly is configured to charge a vehicle and to detect charging data of the vehicle when the light-duty charging pile body is connected to the vehicle;
the air inlet mechanism includes an air inlet box and a filter assembly disposed in the air inlet box, the air inlet box is connected to the light-duty charging pile body, opposite ends of the air inlet box are provided with an air inlet and an air outlet respectively, and outside air passes through the air inlet, the filter assembly and the air outlet in sequence into an interior of the light-duty charging pile body;
the air exhaust mechanism is disposed on the light-duty charging pile body, and the air exhaust mechanism is configured to generate suction force to discharge air in the interior of the light-duty charging pile body.

Based on the above technical content, by providing the air inlet box and the filter assembly, where the filter assembly is disposed in the air inlet box, the outside air passes through the air inlet, the filter assembly and the air outlet in sequence into the interior of the light-duty charging pile body, so that when the light-duty charging pile is subjected to heat dissipation through air exchange, the moisture and dust from air are blocked outside the light-duty charging pile body by the filter assembly. Accordingly, the dust and the moisture will not enter the interior of the light-duty charging pile through the air inlet, so as to solve the problem that the dust and the moisture in the air may enter the interior of the light-duty charging pile through the ventilation opening, affecting the test-and-evaluation data of the light-duty charging pile during the heat dissipation process of the light-duty charging pile.

Optionally, in the light-duty charging pile provided in the present application, the filter assembly includes a first filter member and a waterproof and breathable membrane.

The first filter member is disposed in the air inlet box and at an end of the air inlet box near the air inlet, and the waterproof and breathable membrane is disposed in the air inlet box at an end of the air inlet box near the air outlet.

Based on the above technical content, the outside air is firstly filtered by the first filter member to filter out the dust or impurities in the air, and then passes through the waterproof and breathable membrane to separate the moisture from the air. The dust and moisture in the air will not enter the interior of the light-duty charging pile body, further avoiding interference with the light-duty charging pile body.

Optionally, in the light-duty charging pile provided in the present application, the air inlet box includes a support frame and a cover plate; a side wall of the light-duty charging pile body is provided with a mounting hole, and the support frame is disposed in the mounting hole; one end of the support frame is formed with the air outlet, and the other end of the support frame is covered by the cover plate; the air inlet is located in the cover plate, and a plurality of air inlets are provided at intervals.

Based on the above technical content, the cover plate is provided with the plurality of air inlets; it can be understood that an inner diameter of the air inlet is smaller than that of an end opening of the air inlet box, which may prevent birds or other animals from entering the interior of the light-duty charging pile body through the air inlet, further improving the safety of the light-duty charging pile body.

Optionally, in the light-duty charging pile provided in the present application, the filter assembly further includes a plurality of dust-proof guide members, and the dust-proof guide members are correspondingly communicated with the air inlets. An end of the dust-proof guide member away from the air inlet is open towards a bottom of the light-duty charging pile body.

Based on the above technical content, a channel that can change a direction of the opening of the air inlet is formed, so that the outside air enters the air inlet from a bottom side of the dust-proof guide member. Such a configuration has the rainproof and snowproof effect, thereby improving the safety of the light charging pile body.

Optionally, in the light-duty charging pile provided in the present application, the air exhaust mechanism includes an air exhaust box and an air exhaust fan disposed in the air exhaust box, and the air exhaust box is connected to a side wall of the light-duty charging pile body, and connects the interior of the light-duty charging pile body and the outside of the light-duty charging pile body.

The air exhaust fan is configured to rotate to generate wind, in order to discharge the air in the interior of the light-duty charging pile body off the light-duty charging pile body through the air exhaust box.

Based on the above technical content, the air exhaust fan is turned on and rotates to generate wind, and the wind flows along a direction from the interior of the light-duty charging pile body to the exterior of the light-duty charging pile body. Then the air in the interior of the light-duty charging pile body is discharged, speeding up the air circulation and increasing the heat dissipation rate.

Optionally, in the light-duty charging pile provided in the present application, a second filter is further included, and the second filter is disposed in the air exhaust box and at an end of the air exhaust box away from the light-duty charging pile body.

Based on the above technical content, the second filter may block external debris (such as small animals, leaves, etc.) from entering the interior of the light-duty charging pile body through the air exhaust box. It guarantees the safety of the air exhaust fan and the light-duty charging pile body, without affecting the air exhaust.

Optionally, in the light-duty charging pile provided in the present application, the charging assembly includes a cable, a charging gun and a placement seat.

One end of the cable is connected to the light-duty charging pile body, and the other end of the cable is connected to the charging gun.

The placement seat is disposed on a side wall of the light-duty charging pile body.

The charging gun is configured to be connected to the vehicle when charging the vehicle, and to be placed on the placement seat when charging the vehicle is not required.

Based on the above technical content, the light-duty charging pile body charges the vehicle through the cable and the charging gun. The charging gun can cooperate with the charging port of the vehicle, and the cable has a certain degree of flexibility, which can facilitate the user to drag the cable to find the charging port of the vehicle in an indefinite position, being convenient for the user to use. In addition, the placement seat provides a placement position for a free charging gun, providing a protective effect for the charging gun.

Optionally, in the light-duty charging pile provided in the present application, the charging gun includes a gun body, a gun head and a protective member.

Two ends of the gun body are connected to the gun head and the cable, respectively.

The gun head is configured to connect to the vehicle.

The protective member is disposed at an end of the gun body near the gun head, and the protective member is configured so that when the charging gun is in operation, a part of the protective member abuts against the vehicle; and when the charging gun is not in operation, a part of the protective member abuts against the placement seat.

Based on the above technical content, the protective member has the effect of protecting the stability of the connection between the gun head and the vehicle, and also has a certain sealing effect. Thus, the debris will not enter the vehicle through the gap between the gun head and the vehicle. In addition, the protective member further has the effect of protecting the charging port of the vehicle.

Optionally, in the light-duty charging pile provided in the present application, the protective member includes a suction cup and a vacuum generator.

The vacuum generator is disposed on the suction cup, and the suction cup is disposed along a circumferential direction of the gun body and is sleeved around an outer peripheral side of the gun head.

The suction cup is configured to be adsorbed to the vehicle or the placement seat by a negative pressure generated by the vacuum generator.

Based on the above technical content, the vacuum generator generates the negative pressure, which drives the suction cup to be adsorbed to the vehicle or the placement seat. On one hand, the stability of the connection between the charging gun and the vehicle may be improved during charging of the vehicle. On the other hand, when the charging gun is placed on the placement seat, it has a shockproof effect, and the charging gun is not easy to fall off, thereby protecting the charging gun.

Optionally, the light-duty charging pile provided in the present application further includes a base and a top plate.

A projection of the light-duty charging pile body onto the base is located within the base, and a projection of the light-duty charging pile body onto the top plate is located within the top plate.

The base is connected to a bottom end of the light-duty charging pile body, and the base has a plurality of assembly holes, and the light-duty charging pile body is connected to a mounting surface through the plurality of assembly holes.

The top plate is connected to a top end of the light-duty charging pile body.

Based on the above technical content, the light-duty charging pile body may be quickly installed on the mounting surface, for example, on the ground, through the assembly holes in the base. The projection of the light-duty charging pile body onto the top plate is located within the top plate, so that the top plate has the rainproof and snowproof effect.

### BRIEF DESCRIPTION OF DRAWINGS

FIG. 1 is a structural schematic diagram of a light-duty charging pile provided by an embodiment of the present application.
FIG. 2 is an enlarged structural schematic diagram of part A in FIG. 1.
FIG. 3 is a structural schematic diagram of FIG. 1 from another perspective.
FIG. 4 is an exploded schematic diagram of a partial structure of an air exhaust mechanism in FIG. 3.
FIG. 5 is a schematic diagram of a partial internal structure of an air inlet box in FIG. 2.
FIG. 6 is a schematic diagram of a partial structure of a charging assembly in FIG. 1.
FIG. 7 is a sectional schematic diagram of a cable in FIG. 6.

### Illustration of reference signs:

100. Light-duty charging pile body;
200. Charging assembly; 210. Cable; 211. Wire-cable core; 212. Temperature-resistant filling layer; 213. Shielding layer; 214. Buffer layer; 215. Tensile armor layer; 216. Outer insulation layer; 220. Charging gun; 221. Gun body; 222. Gun head; 223. Protective member; 2231. Suction cup; 2232. Vacuum generator; 224. Handle; 230. Placement seat;
300. Air inlet mechanism; 310. Air inlet box; 3101. Air inlet; 3102. Air outlet; 311. Support frame; 312. Cover plate; 313. Connecting plate; 320. Filter assembly; 321. First filter member; 322. Waterproof and breathable membrane; 330. Dust-proof guide member; 331. Arc plate; 332. Fan-shaped plate;
400. Air exhaust mechanism; 410. Air exhaust box; 420. Air exhaust fan; 430. Second filter member;
500. Base; 510. Assembly hole;
600. Top plate.

After reading and understanding the drawings and detailed descriptions, other aspects can be understood.

### DESCRIPTION OF EMBODIMENTS

As illustrated in the background, new energy electric vehicles are developing rapidly, and the investigation of the adaptability of charging-piles is also carried out simultaneously. For a light-duty charging pile, a charging-pile plug simulator is plugged and mated with a vehicle charging socket, and a vehicle socket simulator is plugged and mated with a charging-pile plug, which enables a fast charging test device to be connected in series between a vehicle and a charging-pile, such that when the new energy electric vehicle is charged, each data thereof is detected.

Due to having circuit components, the light-duty charging pile may generate a lot of heat during operation, causing interference to the charging test of the light-duty charging pile, and affecting the operation of the light-duty charging pile. Generally, a ventilation opening is provided to facilitate air exchange inside the light-duty charging pile, thereby achieving heat dissipation purpose.

However, since the light-duty charging pile is usually provided outdoors or lacks a special isolation device, dust and moisture in the air may enter the light-duty charging pile through the ventilation opening during the heat dissipation. The dust may accumulate on internal components of the light-duty charging pile, which may affect the operation of the components and render cleaning difficult. Excessive moisture may cause a short circuit fault in the circuit, affecting test-and-evaluation data when the vehicle is charged by the light-duty charging pile.

Based on this, embodiments of the present application provide a light-duty charging pile. By providing an air inlet box and a filter assembly, and arranging the filter assembly in the air inlet box, the air outside passes through the air inlet, the filter assembly and the air outlet in sequence into an interior of a light-duty charging pile body, so that when the heat dissipation is carried out through air exchange in the light-duty charging pile, the filter assembly blocks the dust and the moisture in the air outside the light-duty charging pile body, preventing the dust and the moisture from entering the interior of the light-duty charging pile through the air inlet. This solves the problem that during the heat dissipation process of the light-duty charging pile, the dust and the moisture in the air may enter the interior of the light-duty charging pile through the ventilation opening, affecting the test-and-evaluation data of the light-duty charging pile.

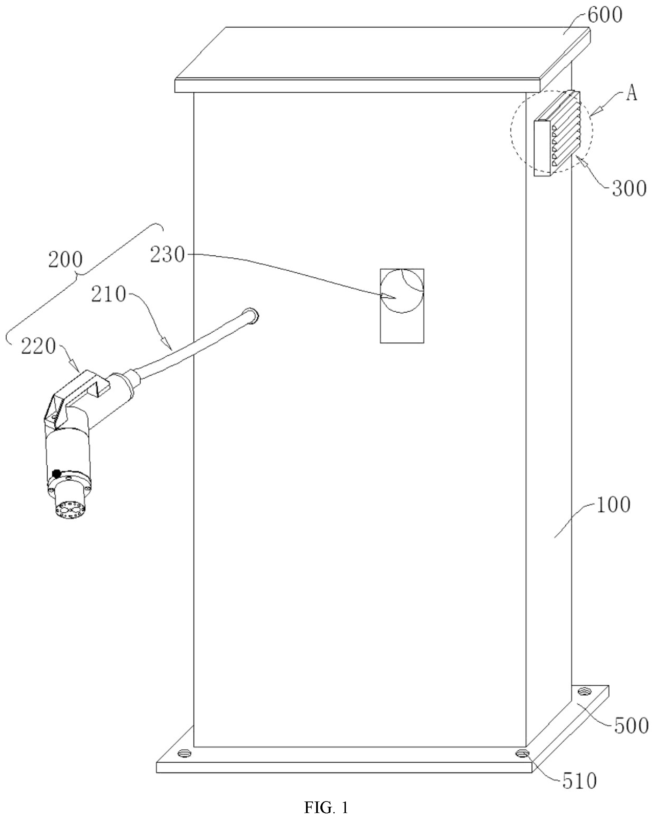

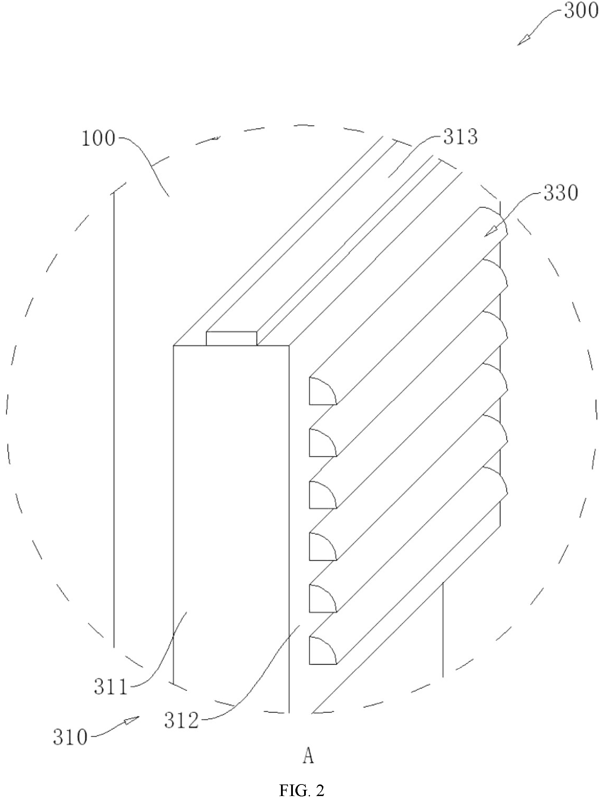

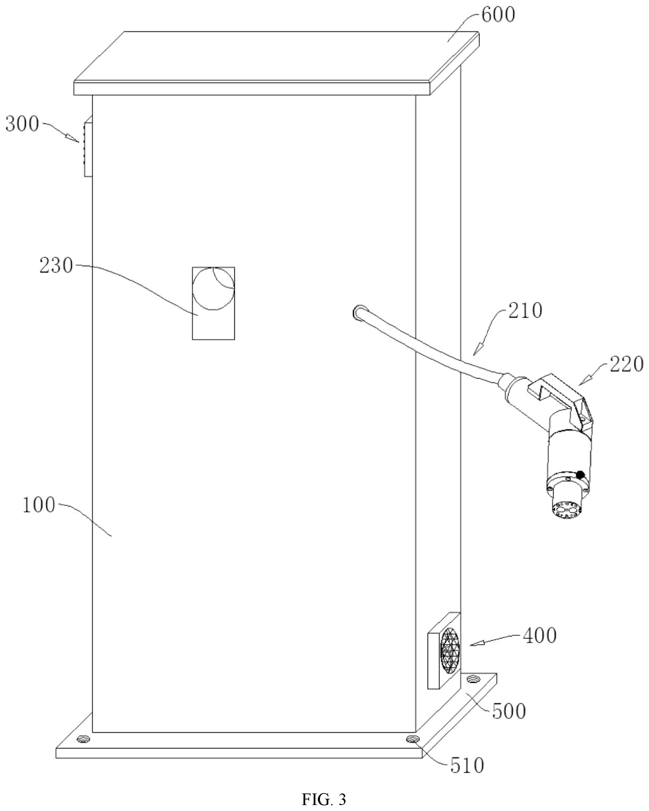

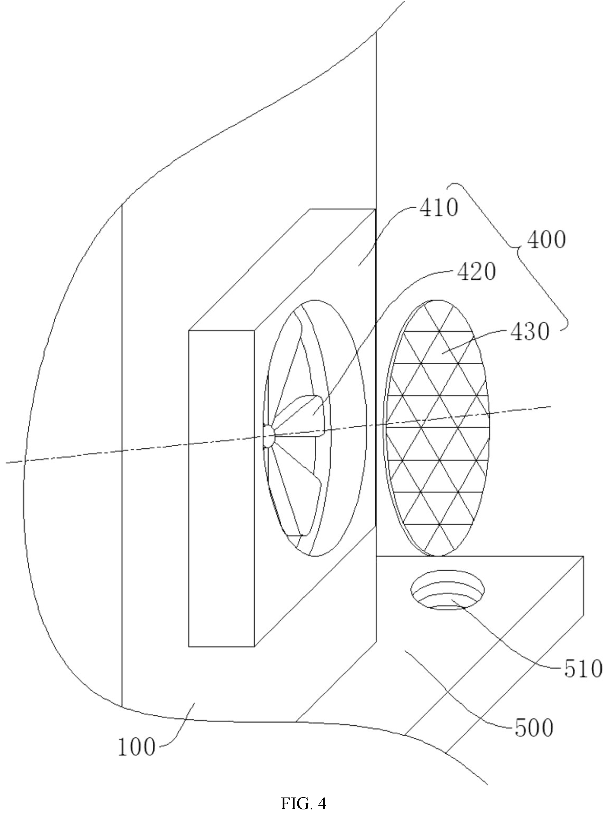

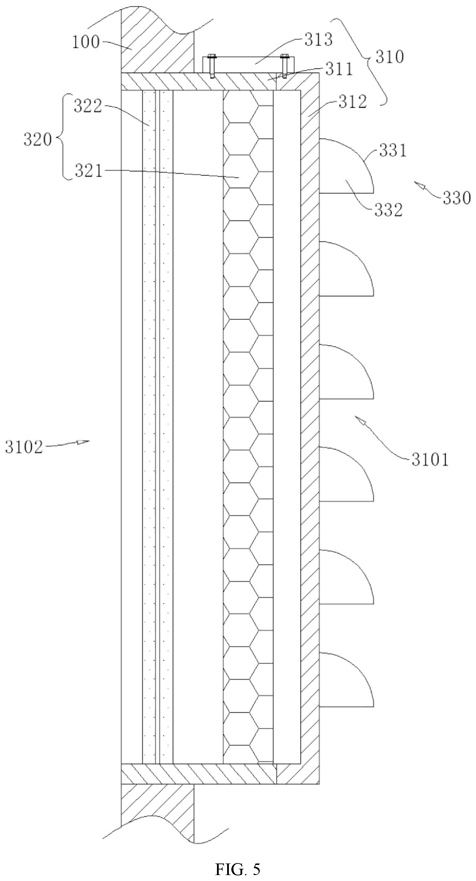

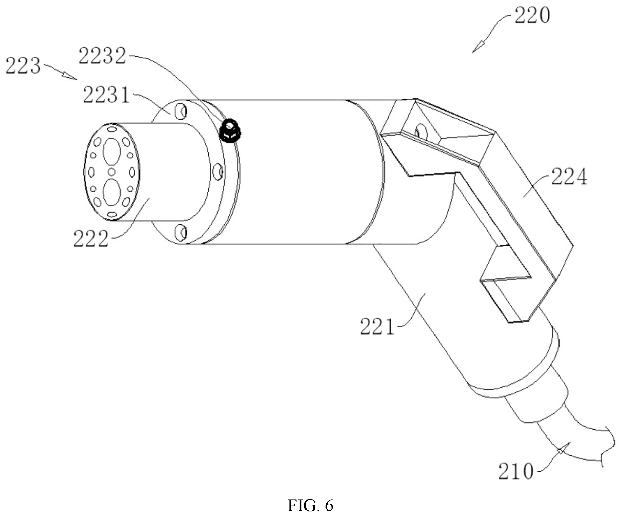

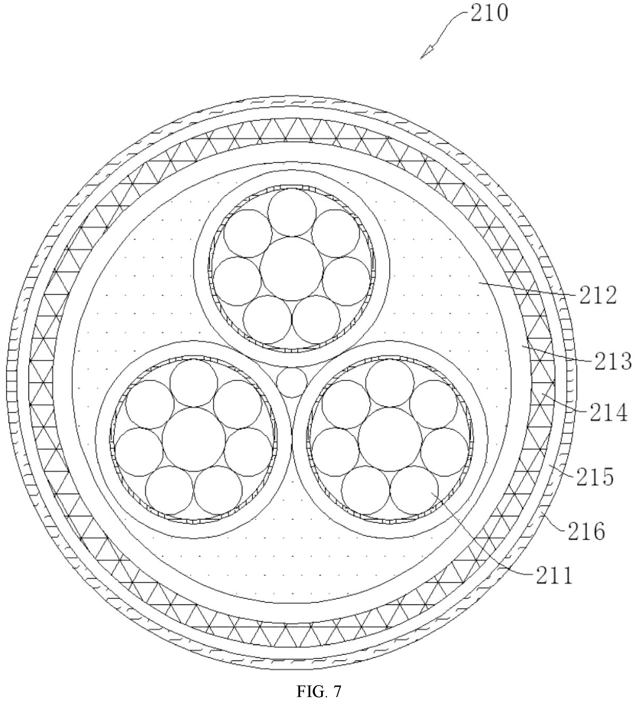

FIG. 1 is a structural schematic diagram of a light-duty charging pile provided by an embodiment of the present application. FIG. 2 is an enlarged structural schematic diagram of part A in FIG. 1. FIG. 3 is a structural schematic diagram of FIG. 1 from another perspective. FIG. 4 is an exploded schematic diagram of a partial structure of an air exhaust mechanism in FIG. 3. FIG. 5 is a schematic diagram of a partial internal structure of an air inlet box in FIG. 2. FIG. 6 is a schematic diagram of a partial structure of a charging assembly in FIG. 1. FIG. 7 is a sectional schematic diagram of a cable in FIG. 6. It should be noted that FIGs. 1-7 show brief schematic diagrams of each component in the light-duty charging pile, and specific structures of the remaining components in the light-duty charging pile are not limited to the illustration in FIG. 1 to FIG. 7.

Hereinafter the present application is described in detail in combination with the drawings and the specific embodiments.

Referring to FIG. 1 to FIG. 5, the embodiments of the present application provide a light-duty charging pile for testing and evaluating a vehicle and a charging-pile, and the light-duty charging pile includes a light-duty charging pile body 100, a charging assembly 200, an air inlet mechanism 300 and an air exhaust mechanism 400.

In this technical field, the light-duty charging pile is connected in series between the new energy vehicle and the charging-pile, such that the new energy vehicle is charged, while each data is detected, to achieve the adaptability test of the charging-pile.

The light-duty charging pile body 100 is configured to connect to the charging-pile.

The charging assembly 200 is disposed on the light-duty charging pile body 100, and the charging assembly 200 is configured to charge the vehicle and detect charging data of the vehicle when the light-duty charging pile body 100 is connected to the vehicle. Here, the light-duty charging pile body 100 is provided with a data detection device, of which a specific structure is not excessively limited here, and by which the type and quantity of the data obtained and the like are not excessively limited here.

The air inlet mechanism 300 includes an air inlet box 310 and a filter assembly 320 disposed in the air inlet box 310; the air inlet box 310 is connected to the light-duty charging pile body 100; opposite ends of the air inlet box 310 are provided with an air inlet 3101 and an air outlet 3102 respectively; and the outside air passes through the air inlet 3101, the filter assembly 320 and the air outlet 3102 in sequence, and enters an interior of the light-duty charging pile body 100.

The air exhaust mechanism 400 is provided on the light-duty charging pile body 100, and is configured to generate suction to discharge the air in the interior of the light-duty charging pile body 100.

In the above embodiment, when the light-duty charging pile body 100 is in operation, the outside air enters the air inlet box 310 through the air inlet 3101, and then passes through the filter assembly 320. The filter assembly 320 filters the outside air, so that the clean air enters the interior of the light-duty charging pile body 100 through the air outlet 3102. The dust and moisture may not enter the interior of the light-duty charging pile body 100 through the air inlet 3101, which solves the problem that the dust and moisture in the air may enter the interior of the light-duty charging pile body 100 through the ventilation opening during the heat dissipation process of the light-duty charging pile, affecting the test-and-evaluation data of the light-duty charging pile.

The air exhaust mechanism 400 generates suction to discharge the air in the interior of the light-duty charging pile body 100, accelerating the air circulation in the interior of the light-duty charging pile body 100, and improving the heat dissipation efficiency.

As shown in FIG. 5, in a possible embodiment, the filter assembly 320 includes a first filter member 321 and a waterproof and breathable membrane 322.

The first filter member 321 is disposed in the air inlet box 310 and at an end of the air inlet box 310 near the air inlet 3101, and the waterproof and breathable membrane 322 is disposed in the air inlet box 310 and at an end of the air inlet box 310 near the air outlet 3102.

In a specific implementation, the first filter member 321 is configured to filter out the dust and impurities in the air, and it can be a sponge, where the cost of sponge is low; the first filter member 321 can also be a felt cloth, where the felt cloth has better toughness and air permeability, and can extend the service life of the first filter member 321. The waterproof and breathable membrane 322 has breathable holes. The spacing between the gas molecules in the air is large, and the gas molecules can pass through the breathable holes of the waterproof and breathable membrane 322 during the diffusion movement. The spacing between the water molecules in the air is less than the spacing of the breathable holes, and under the action of surface tension, the water molecules cannot pass through the waterproof and breathable membrane 322. That is to say, it plays a waterproof role. The waterproof and breathable membrane 322 has wide climate applicability, and can be applied to regions with various climatic conditions. Meanwhile, the waterproof and breathable membrane 322 further has high lubricity, and may not adhere to impurities, thereby preventing the air inlet box 310 from being blocked.

In the above embodiment, the first filter member 321 is disposed in the air inlet box 310 and at the end of the air inlet box 310 near the air inlet 3101, and the waterproof and breathable membrane 322 is disposed in the air inlet box 310 and at the end of the air inlet box 310 near the air outlet 3102. It can be understood that the outside air is firstly filtered by the first filter member 321 to filter out the dust or impurities in the air, and then passes through the waterproof and breathable membrane 322 to separate the moisture in the air, thereby preventing the dust and moisture in the air from entering the interior of the light-duty charging pile body 100, and further avoiding interference with the light-duty charging pile body 100.

In a possible embodiment, the air inlet box 310 includes a support frame 311 and a cover plate 312.

A side wall of the light-duty charging pile body 100 is provided with a mounting hole, and the support frame 311 is disposed in the mounting hole. One end of the support frame 311 is formed with the air outlet 3102, and the other end of the support frame 311 is covered by the cover plate 312. The air inlet 3101 is located in the cover plate 312, and multiple air inlets 3101 are provided at intervals.

In a specific implementation, the shape of the mounting hole is matched with the support frame 311. A cross-section of the support frame 311 in the vertical direction may have a circular shape, or a square shape, where this structure is not excessively limited. In the figures, the cross-section of the support frame 311 in the vertical direction is represented as a square shape. Correspondingly, the mounting hole is a square hole. The square support frame 311 and the square hole are easy to process, while can be correspondingly matched to the square light-duty charging pile body 100, which is conducive to improving the overall aesthetics.

In a possible embodiment, a connecting plate 313 is provided between the cover plate 312 and the air inlet box 310, and the cover plate 312 is connected to the air inlet box 310 via the connecting plate 313. Two sides of the connecting plate 313 are in threaded connection with the air inlet box 310 and the cover plate 312 respectively via a plurality of bolts, so as to achieve the detachable connection between the cover plate 312 and the air inlet box 310. It facilitates the staff to open an interior of the air inlet box 310 from the outside, and to overhaul and maintain the interior of the air inlet box 310.

In the above embodiment, an end of the air inlet box 310 is provided with the cover plate 312, and the cover plate 312 is provided with multiple air inlets 3101 disposed at intervals. It can be understood that an inner diameter of the air inlet 3101 is smaller than that of an end opening of the air inlet box 310, which may prevent birds or other animals from entering the interior of the light-duty charging pile body 100 through the air inlet 3101, further improving the safety of the light-duty charging pile body 100.

In a possible embodiment, the filter assembly 320 further includes a plurality of dust-proof guide members 330, and the dust-proof guide members 330 are correspondingly communicated with the air inlets 3101. An end of the dust-proof guide member 330 away from the air inlet 3101 is open towards a bottom of the light-duty charging pile body 100.

The air inlet 3101 may be provided as a long strip. The dust-proof guide member 330 includes an arc plate 331 and fan plates 332 provided at both ends of the arc plate 331, the arc plate 331 and the fan plates 332 jointly enclose to form a channel that can change a direction of the opening of the air inlet 3101, so that the outside air enters the air inlet 3101 from a bottom side of the arc plate 331. It can be understood that such a configuration has the rainproof and snowproof effect, thereby improving the safety of the light charging pile body 100.

In a possible embodiment, the air exhaust mechanism 400 includes an air exhaust box 410 and an air exhaust fan 420 disposed in the air exhaust box 410, and the air exhaust box 410 is connected to a side wall of the light-duty charging pile body 100, and connects the interior of the light-duty charging pile body 100 and the outside.

The air exhaust fan 420 is configured to rotate to generate wind, in order to discharge the air in the interior of the light-duty charging pile body 100 off the light-duty charging pile body 100 through the air exhaust box 410.

In the above embodiment, the air exhaust fan 420 is turned on and rotates to generate wind, and the wind flows along a direction from the interior of the light-duty charging pile body 100 to the exterior of the light-duty charging pile body 100. Then the air in the interior of the light-duty charging pile body 100 is discharged, speeding up the air circulation and increasing the heat dissipation efficiency. The air exhaust fan 420 has a simple structure and low production cost.

In a possible embodiment, a second filter 430 is further included, and the second filter 430 is disposed at an end of the air exhaust box 410 away from the light-duty charging pile body 100.

In the above embodiment, the second filter 430 may be wire mesh or grille, of which a specific structure is not limited herein, as long as it can block external debris (such as small animals, leaves, etc.) from entering the interior of the light-duty charging pile body 100 through the air exhaust box 410. It protects the safety of the air exhaust fan 420 and the light-duty charging pile body 100, without affecting the air exhaust.

Referring to FIG. 1, FIG. 6, and FIG. 7, in a possible embodiment, the charging assembly 200 includes a cable 210, a charging gun 220, and a placement seat 230.

One end of the cable 210 is connected to the light-duty charging pile body 100, and the other end of the cable 210 is connected to the charging gun 220.

The placement seat 230 is disposed on the side wall of the light-duty charging pile body 100. The placement seat 230 is a related technology in this field, of which a specific structure is not limited herein.

The charging gun 220 is configured to be connected to the vehicle when charging the vehicle, and to be placed on the placement seat 230 when charging vehicle is not required.

In the above embodiment, the light-duty charging pile body 100 charges the vehicle through the cable 210 and the charging gun 220. The charging gun 220 can cooperate with the charging port of the vehicle, and the cable 210 has a certain degree of flexibility, which can facilitate the user to drag the cable 210 to find the charging port of the vehicle in an indefinite position, being convenient for the user.

In addition, the placement seat 230 provides a placement position for a free charging gun 220, providing a protective effect for the charging gun 220.

In a possible embodiment, the charging gun 220 includes a gun body 221, a gun head 222 and a protective member 223.

The gun body 221 is further provided with a handle 224, to facilitate the user to operate the gun body 221.

Two ends of the gun body 221 are connected to the gun head 222 and the cable 210, respectively.

The gun head 222 is configured to connect with the vehicle.

The protective member 223 is disposed at an end of the gun body 221 near the gun head 222, and the protective member 223 is configured so that when the charging gun 220 is in operation, a part of the protective member 223 abuts against the vehicle, and when the charging gun 220 is not in operation, a part of the protective member 223 abuts against the placement seat 230.

In the above embodiment, when the charging gun 220 is in operation, the protective member 223 abuts against the vehicle. It can be understood that at this time, the protective member 223 is disposed between the gun head 222 and the vehicle, which has the effect of protecting the stability of the connection between the gun head 222 and the vehicle, and also has a certain sealing effect. Thus, the debris will not enter the vehicle through the gap between the gun head 222 and the vehicle. In addition, the protective member 223 further has the effect of protecting the charging port of the vehicle.

In a possible embodiment, the protective member 223 includes a suction cup 2231 and a vacuum generator 2232.

The vacuum generator 2232 is disposed on the suction cup 2231, and the suction cup 2231 is disposed along a circumferential direction of the gun body 221 and is sleeved around an outer peripheral side of the gun head 222.

The suction cup 2231 is configured to be adsorbed to the vehicle or the placement seat 230 when a negative pressure is generated by the vacuum generator 2232.

In a specific implementation, the vacuum generator 2232 can be a mechanical vacuum generator 2232, which has a simple structure and does not require consuming electrical energy. The vacuum generator 2232 can also be a vacuum pump. By detecting the connection status between the vehicle and the charging gun 220 via a sensor, when the vehicle is connected to the charging gun 220, the vacuum pump is turned on to enable the suction cup 2231 to generate the negative pressure.

In the above embodiment, the vacuum generator 2232 generates the negative pressure, which drives the suction cup 2231 to be adsorbed to the vehicle or the placement seat 230. On one hand, the stability of the connection between the charging gun 220 and the vehicle may be improved when the vehicle is charged. On the other hand, when the charging gun 220 is placed on the placement seat 230, it has a shockproof effect, and the charging gun 220 is not easy to fall off, thereby protecting the charging gun 220.

In a possible embodiment, referring to FIG. 7, the cable 210 includes a wire-cable core 211, a temperature-resistant filling layer 212, a shielding layer 213, a buffer layer 214, a tensile armor layer 215, and an outer insulation layer 216.

The wire-cable core 211 includes at least three wire-cables, an outer side of the wire-cable core 211 is wrapped with the temperature-resistant filling layer 212, an outer surface of the temperature-resistant filling layer 212 is wrapped with the shielding layer 213, an outer surface of the shielding layer 213 is wrapped with the buffer layer 214, an outer surface of the buffer layer 214 is wrapped with the tensile armor layer 215, and an outer surface of the tensile armor layer 215 is wrapped with the outer insulation layer 216.

The tensile armor layer 215 is made of tensile rubber material with a flexible mesh inside, and the flexible mesh is tightly weaved and pressed into the tensile rubber, which can improve the tensile resistance of the cable 210.

In a possible embodiment, referring to FIG. 3 and FIG. 4, the light-duty charging pile further includes a base 500 and a top plate 600.

A projection of the light-duty charging pile body 100 onto the base 500 is located within the base 500, and a projection of the light-duty charging pile body 100 onto the top plate 600 is located within the top plate 600.

The base 500 is connected to a bottom end of the light-duty charging pile body 100, and the base 500 has a plurality of assembly holes 510, and the light-duty charging pile body 100 is connected to a mounting surface through the plurality of assembly holes 510. The plurality of assembly holes 510 are evenly disposed at the four corners of the base 500.

The top plate 600 is connected to a top end of the light-duty charging pile body 100.

In the above embodiment, the light-duty charging pile body 100 may be quickly installed by the staff on the mounting surface, for example, on the ground, through the assembly holes 510 in the base 500. The projection of the light-duty charging pile body 100 onto the top plate 600 is located within the top plate 600, so that the top plate 600 has the rainproof and snowproof effect.

Embodiments of the present application provide a light-duty charging pile, which is implemented according to the following principle: the light-duty charging pile includes the light-duty charging pile body 100, the charging assembly 200, the air inlet mechanism 300 and the air exhaust mechanism 400; the air inlet mechanism 300 is provided with the air inlet box 310 and the filter assembly 320 disposed in the air inlet box 310; the outside air enters the air inlet box 310 through the air inlet 3102, and then passes through the filter assembly 320; the filter assembly 320 filters the outside air, so that the clean air enters the interior of the light-duty charging pile body 100 through the air outlet 3102; the dust and the moisture will not enter the interior of the light-duty charging pile through the air inlet 3101, so as to solve the problem that the dust and the moisture in the air may enter the interior of the light-duty charging pile through the ventilation opening, affecting the test-and-evaluation data of the light-duty charging pile during the heat dissipation process of the light-duty charging pile.

The above descriptions are only the specific embodiments of the present application, but the protection scope of the present application is not limited to these. Any amendments or replacements in the technical scope disclosed in the present application, which can be easily conceived by those skilled in this technical field, should be covered by the protection scope of the present application. Therefore, the protection scope of the present application shall be subject to the protection scope of the claims.

## Claims

1. A light-duty charging pile, configured for testing and evaluating a vehicle and a charging-pile, wherein the light-duty charging pile comprises a light-duty charging pile body (100), a charging assembly (200), an air inlet mechanism (300) and an air exhaust mechanism (400);
the light-duty charging pile body (100) is configured for connecting to the charging-pile;
the charging assembly (200) is disposed on the light-duty charging pile body (100), and the charging assembly (200) is configured to charge the vehicle and to detect charging data of the vehicle when the light-duty charging pile body (100) is connected to the vehicle;
the air inlet mechanism (300) comprises an air inlet box (310) and a filter assembly (320) disposed in the air inlet box (310), and the air inlet box (310) is connected to the light-duty charging pile body (100); opposite ends of the air inlet box (310) are provided with an air inlet (3101) and an air outlet (3102) respectively, and outside air passes through the air inlet (3101), the filter assembly (320) and the air outlet (3102) in sequence and enters an interior of the light-duty charging pile body (100);
the air exhaust mechanism (400) is disposed on the light-duty charging pile body (100), and is configured to generate suction force to discharge air in the interior of the light-duty charging pile body (100).

2. The light-duty charging pile according to claim 1, wherein the filter assembly (320) comprises a first filter member (321) and a waterproof and breathable membrane (322);
the first filter member (321) is disposed in the air inlet box (310) and at an end of the air inlet box (310) near the air inlet (3101), and the waterproof and breathable membrane (322) is disposed in the air inlet box (310) and at an end of the air inlet box (310) near the air outlet (3102).

3. The light-duty charging pile according to claim 1, wherein the air inlet box (310) comprises a support frame (311) and a cover plate (312); a side wall of the light-duty charging pile body (100) is provided with a mounting hole, and the support frame (311) is disposed in the mounting hole; one end of the support frame (311) is formed with the air outlet (3102), and the other end of the support frame (311) is covered by the cover plate (312); the air inlet (3101) is located in the cover plate (312), and a plurality of air inlets (3101) are provided at intervals.

4. The light-duty charging pile according to claim 3, wherein the filter assembly (320) further comprises a plurality of dust-proof guide members (330), and the dust-proof guide members (330) are correspondingly communicated with the air inlets (3101); an end of the dust-proof guide members (330) away from the air inlet (3101) is open towards a bottom of the light-duty charging pile body (100).

5. The light-duty charging pile according to claim 1, wherein the air exhaust mechanism (400) comprises an air exhaust box (410) and an air exhaust fan (420) disposed in the air exhaust box (410), and the air exhaust box (410) is connected to a side wall of the light-duty charging pile body (100), and connects the interior of the light-duty charging pile body (100) and an outside of the light-duty charging pile body (100);
the air exhaust fan (420) is configured to rotate to generate wind, in order to discharge the air in the interior of the light-duty charging pile body (100) off the light-duty charging pile body (100) through the air exhaust box (410).

6. The light-duty charging pile according to claim 5, further comprising a second filter member (430), the second filter (430) being disposed at an end of the air exhaust box (400) away from the light-duty charging pile body (100).

7. The light-duty charging pile according to claim 1, wherein the charging assembly (200) comprises a cable (210), a charging gun (220) and a placement seat (230);
one end of the cable (210) is connected to the light-duty charging pile body (100), and the other end of the cable (210) is connected to the charging gun (220);
the placement seat (230) is disposed on a side wall of the light-duty charging pile body (100);
the charging gun (220) is configured to be connected to the vehicle when charging the vehicle, and to be placed on the placement seat (230) in case that charging the vehicle is not required.

8. The light-duty charging pile according to claim 7, wherein the charging gun (220) comprises a gun body (221), a gun head (222) and a protective member (223);
two ends of the gun body (221) are connected to the gun head (222) and the cable (210), respectively;
the gun head (222) is configured to connect with the vehicle;
the protective member (223) is disposed at an end of the gun body (221) near the gun head (222), and the protective member (223) is configured so that when the charging gun (220) is in operation, a part of the protective member (223) abuts against the vehicle, and when the charging gun (220) is not in operation, a part of the protective member (223) abuts against the placement seat (230).

9. The light-duty charging pile according to claim 8, wherein the protective member (223) comprises a suction cup (2231) and a vacuum generator (2232);
the vacuum generator (2232) is disposed on the suction cup (2231), and the suction cup (2231) is disposed along a circumferential direction of the gun body (221) and is sleeved around an outer peripheral side of the gun head (222);
the suction cup (2231) is configured to be adsorbed to the vehicle or the placement seat (230) by a negative pressure generated by the vacuum generator (2232).

10. The light-duty charging pile according to any one of claims 1-9, further comprising a base (500) and a top plate (600);
a projection of the light-duty charging pile body (100) onto the base (500) is located within the base (500), and a projection of the light-duty charging pile body (100) onto the top plate (600) is located within the top plate (600);
the base (500) is connected to a bottom end of the light-duty charging pile body (100), and the base (500) has a plurality of assembly holes (510), and the light-duty charging pile body (100) is connected to a mounting surface through the plurality of assembly holes (510);
the top plate (600) is connected to a top end of the light-duty charging pile body (100).
